# EUROPEAN PATENT APPLICATION

(11) **EP 4 712 745 A1**
(43) Date of publication of application: **18.03.2026**
(21) Application number: 25199790.4
(22) Date of filing: 03.09.2025
(51) Int. Cl.: H10K 59/121, H10K 59/123, H10K 59/124, H10K 59/131

(54) **DISPLAY DEVICE**

(30) Priority: 12.09.2024 KR 20240124787
(71) Applicant: Samsung Display Co., Ltd., Yongin-si, Gyeonggi-do 17113 (KR)
(72) Inventor: Son, Sunkwun, 17113 Yongin-si, Gyeonggi-do (KR); Lee, Cheol-Gon, 17113 Yongin-si, Gyeonggi-do (KR)
(74) Representative: Gulde & Partner

(57) **Abstract**

Provided is a display device (10) including a substrate (100), a first transistor (T1) positioned on the substrate (100) and including a first semiconductor layer (510) and a first gate electrode (520), a second transistor (T2) positioned on the first transistor (T1) and including a second semiconductor layer (550) and a second gate electrode (571), and a light-emitting element (400) positioned on the second transistor (T2) and electrically connected to the first transistor (T1), wherein the first gate electrode (520) of the first transistor (T1) and the second semiconductor layer (550) of the second transistor (T2) are electrically connected through a contact hole.

## Description

### BACKGROUND

### 1. Field

One or more embodiments relate to a display device.

### 2. Description of the Related Art

Nowadays, various flat panel display devices are developed for overcoming many drawbacks of cathode ray tubes such as heavy weight and bulk volume. Flat panel display devices may include liquid crystal displays (LCDs), field emission displays (FEDs), plasma display panels (PDPs), organic light-emitting diode (OLED) displays, etc.

Among those flat panel display devices, organic light-emitting diode (OLED) displays output images using organic light-emitting diodes, which emit light through the recombination of electrons and holes. These OLED displays are receiving attention as next-generation displays by virtue of fast response speed and operation with low power consumption.

### SUMMARY

One or more embodiments provide a display device with improved integration density.

However, exemplary embodiments of the disclosure are not restricted to the one set forth herein. The other exemplary embodiments of the disclosure will become more apparent to one of ordinary skill in the art to which the disclosure pertains by referencing the detailed description of the disclosure given below. The technical scope of the disclosure is defined by the appended claims.

Additional aspects will be set forth in part in the description which follows and, in part, will be apparent from the description, or may be learned by practice of the presented embodiments of the disclosure.

According to one or more embodiments of a first aspect, a display device (or more specifically a sub-pixel) includes a substrate, a first transistor positioned on the substrate and including a first semiconductor layer and a first gate electrode, a second transistor positioned on the first transistor and including a second semiconductor layer and a second gate electrode, and a light-emitting element positioned on the second transistor and electrically connected to the first transistor, wherein the first gate electrode of the first transistor and the second semiconductor layer of the second transistor are electrically connected through a contact hole.

In an embodiment, the display device (or sub-pixel) may further include a conductive layer positioned on an insulating layer which may cover the second semiconductor layer, and which may be electrically connected to the first gate electrode and the second semiconductor layer through the contact hole, and at least a portion of the conductive layer may vertically overlap the first gate electrode and the second semiconductor layer.

In an embodiment, the contact hole may expose a side surface of a source region of the second transistor.

In an embodiment, the display device (or sub-pixel) may further include a third transistor positioned on a same layer as the second transistor, and the third transistor may include the second semiconductor layer and a third gate electrode.

In an embodiment, the display device (or sub-pixel) may further include a first scan line and a second scan line positioned on a same layer between the first transistor and the second transistor, the first scan line may form a dual gate of the second transistor together with the second gate electrode, and the second scan line may form a dual gate of the third transistor together with the third gate electrode.

In an embodiment, the first scan line and the second scan line may be arranged parallel to each other.

In an embodiment, the display device (or sub-pixel) may further include a first voltage line and an initialization voltage line positioned on a same layer between the second gate electrode and the light-emitting element.

In an embodiment, the first voltage line and the initialization voltage line may be arranged parallel to the first scan line.

In an embodiment, two sub-pixels, which are arranged adjacent to each other in a direction perpendicular to a longitudinal direction of the first voltage line with respect to the first voltage line (thus forming a sub-pixel arrangement), may share a first voltage.

In an embodiment, the first semiconductor layer may include polycrystalline silicon and the second semiconductor layer may include an oxide semiconductor.

According to one or more embodiments of a second aspect, a display device includes a substrate including a display area and a peripheral area positioned outside the display area, a plurality of sub-pixels positioned in the display area, and a plurality of first voltage lines extending in a first direction and configured to apply a first voltage to the plurality of sub-pixels, wherein two sub-pixels share a first voltage line of the plurality of first voltage lines, wherein two sub-pixels share a first voltage line of the plurality of first voltage lines, the two sub-pixels being arranged adjacent to each other in a second direction perpendicular to the first direction with respect to the first voltage line.

In one embodiment, the two sub-pixels may be symmetrical with respect to the first voltage line.

In an embodiment, each of the two sub-pixels may include a first scan line, a second scan line, and an initialization voltage line which are parallel to the first direction.

In an embodiment, each of the plurality of sub-pixels may include a first transistor positioned on the substrate and including a first semiconductor layer and a first gate electrode, a second transistor positioned on the first transistor and including a second semiconductor layer and a second gate electrode, and a light-emitting element positioned on the second transistor and electrically connected to the first transistor, and the first gate electrode of the first transistor and the second semiconductor layer of the second transistor may be electrically connected through a contact hole. Alternatively, each of the plurality of sub-pixels may be a sub-pixel according to one or more embodiments of the first aspect.

In an embodiment, the display device may further include a conductive layer positioned on an insulating layer which may cover the second semiconductor layer, and which may be electrically connected to the first gate electrode and the second semiconductor layer through the contact hole, and at least a portion of the conductive layer may vertically overlap the first gate electrode and the second semiconductor layer.

In an embodiment, the contact hole may expose a side surface of a source region of the second transistor.

In an embodiment, the display device may further include a third transistor positioned on a same layer as the second transistor, and the third transistor may include the second semiconductor layer and a third gate electrode.

In an embodiment, the display device may further include a first scan line and a second scan line positioned on a same layer between the first transistor and the second transistor, the first scan line may form a dual gate of the second transistor together with the second gate electrode, and the second scan line may form a dual gate of the third transistor together with the third gate electrode.

In an embodiment, an area of the first gate electrode may be larger than an area of a channel region of the first transistor on a plan view.

In an embodiment, the first semiconductor layer may include polycrystalline silicon and the second semiconductor layer may include an oxide semiconductor.

According to one or more embodiments of a third aspect, there is provided an electronic device including a display device, wherein the display device includes a substrate, a first transistor positioned on the substrate and including a first semiconductor layer and a first gate electrode, a second transistor positioned on the first transistor and including a second semiconductor layer and a second gate electrode, and a light-emitting element positioned on the second transistor and electrically connected to the first transistor, wherein the first gate electrode of the first transistor and the second semiconductor layer of the second transistor are electrically connected through a contact hole. Alternatively, each of the plurality of sub-pixels may be a display device according to one or more embodiments of the first or second aspect.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments of the disclosure will be more apparent from the following description taken in conjunction with the accompanying drawings, in which:

The following drawings attached to this specification illustrate preferred embodiments of the disclosure and, together with the detailed description of the disclosure described below, serve to further understand the technical idea of the disclosure; therefore, the disclosure should not be interpreted as being limited to matters described in such drawings:
FIG. 1 is a schematic plan view of one example of a display device according to one embodiment;
FIG. 2 is a schematic block diagram of a structure of the display device of FIG. 1;
FIG. 3 is an equivalent circuit diagram of one sub-pixel of the display device of FIG. 1;
FIG. 4 is a schematic layout diagram illustrating the positions of thin-film transistors, capacitors, etc., arranged in sub-pixels included in the display device of FIG. 1;
FIG. 5 is a schematic plan view illustrating an example of two adjacent sub-pixels of the display device of FIG. 1;
FIG. 6 is a schematic cross-sectional view illustrating a portion of the display device of FIG. 1;
FIG. 7 is an enlarged schematic cross-sectional view illustrating one example of a part A of FIG. 6; and
FIG. 8 is a schematic diagram of an example in which an electronic device including a display device according to embodiments is implemented as a head-mounted display.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

As the disclosure allows for various changes and numerous embodiments, certain embodiments will be illustrated in the drawings and described in detail in the written description. Effects and features of the disclosure and methods of achieving the same will be apparent with reference to embodiments and drawings described below in detail. The disclosure may, however, be embodied in many different forms and should not be construed as being limited to the embodiments set forth herein.

In the following embodiments, the terms "first," "second," etc. are not used in a restrictive sense and are used to distinguish on element from another.

The singular forms as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

In the following embodiments, it will be understood that, when a portion such as film, region, or element is referred to as being "on" another portion, this may include not only a case where the portion is directly on the other portion, but also a case where intervening films, regions, or elements may be present therebetween.

Sizes of elements in the drawings may be exaggerated or reduced for convenience of explanation. For example, because sizes and/or thicknesses of elements in the drawings are arbitrarily illustrated for convenience of explanation, the disclosure is not limited thereto.

Hereinafter, embodiments will be described in detail with reference to the accompanying drawings. When describing embodiments with reference to the accompanying drawings, the same or corresponding elements are denoted by the same reference numerals, and redundant descriptions thereof are omitted.

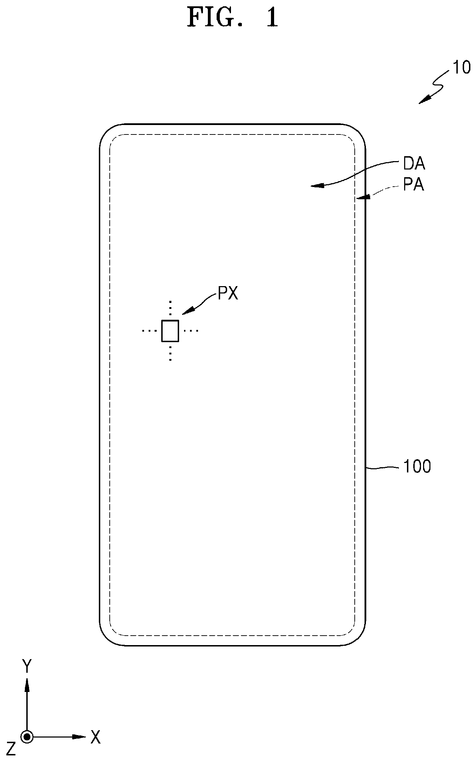

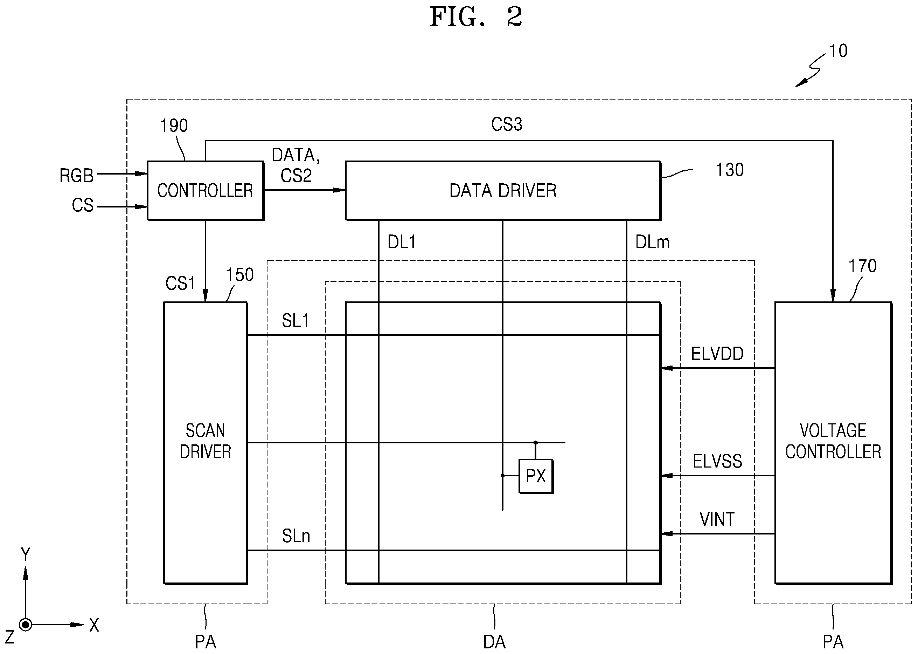

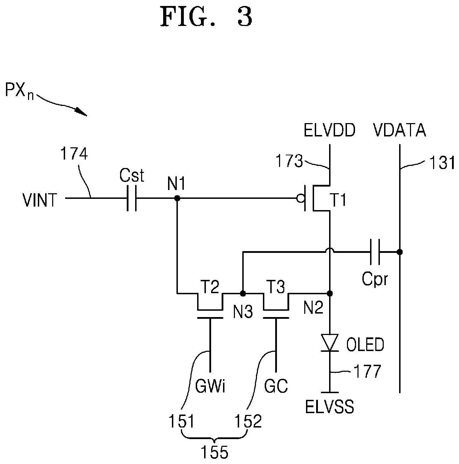

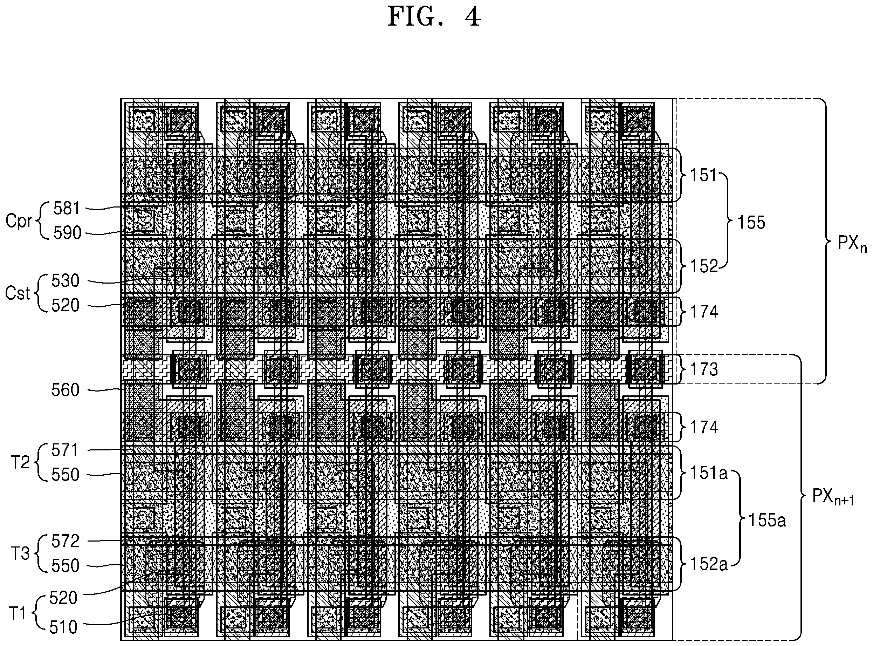

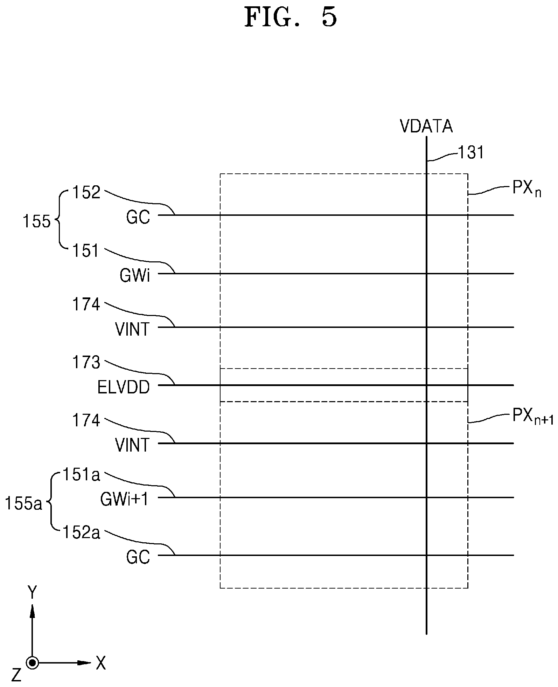

FIG. 1 is a schematic plan view of one example of a display device according to one embodiment, FIG. 2 is a schematic block diagram of a structure of the display device of FIG. 1, FIG. 3 is an equivalent circuit diagram of one sub-pixel of the display device of FIG. 1, FIG. 4 is a schematic layout diagram illustrating the positions of thin-film transistors, capacitors, etc., arranged in sub-pixels included in the display device of FIG. 1, and FIG. 5 is a schematic plan view illustrating an example of two adjacent sub-pixels of the display device of FIG. 1.

First, referring to FIGS. 1 and 2, a display device 10 according to one embodiment may include a substrate 100 which has a display area DA for displaying an image and a peripheral area PA located outside the display area DA.

A plurality of scan lines SL1, ..., SLn extending along a first direction x, a plurality of data lines DL1, ..., DLm extending along a second direction y perpendicular to the first direction x, and a plurality of sub-pixels PX may located in the display area DA. Here, m and n denote natural numbers.

Wirings, along which electrical signals may be applied to the plurality of sub-pixels PX, may include a plurality of scan lines SL1, ..., SLn, and a plurality of data lines DL1, ..., DLm. The plurality of scan lines SL1, ..., SLn, for example, may be arranged in a plurality of rows extending in the first direction x, to transmit scan signals to the sub-pixels PX. The plurality of data lines DL1, ..., DLm, for example, may be arranged in a plurality of columns extending in the second direction y, to transmit data signals to the sub-pixels PX. The plurality of sub-pixels PX may be positioned at intersections of the plurality of scan lines SL1, ..., SLn and the plurality of data lines DL1, ..., DLm.

The sub-pixels P may each include a light-emitting element which emits red light, green light, blue light, or white light. For example, each sub-pixel PX may include an organic light-emitting diode OLED as a light-emitting element.

In the peripheral area PA may be arranged a data driver 130 for applying data signals to the display area DA, a scan driver 150 for applying scan signals to the display area DA, a voltage controller 170 for controlling voltages supplied to the display area DA, and a controller 190 that may control the data driver 130, the scan driver 150, and the voltage controller 170.

The voltage controller 170 may generate and control a first voltage ELVDD, a second voltage ELVSS, and an initialization voltage VINT which are applied to the display area DA.

The first voltage ELVDD, the second voltage ELVSS, and the initialization voltage VINT may be applied to the plurality of sub-pixels PX. For example, the first voltage ELVDD may be a positive voltage, and the second voltage ELVSS may be a negative voltage or a ground voltage. That is, the second voltage ELVSS may have a lower level than the first voltage ELVDD.

The controller 190 may receive image signals RGB and control signals CS from the exterior (e.g., a system board). The controller 190 may generate image data DATA by converting a data format of the image signals RGB to be appropriate to an interface between the data driver 130 and the controller 190. The controller 190 may apply the image data DATA having the converted data format to the data driver 130.

The controller 190 may generate and output a first control signal CS1 and a second control signal CS2, in response to the control signal CS applied from the exterior. The first control signal CS1 may be defined as a scan control signal and the second control signal CS2 may be defined as a data control signal. The first control signal CS1 may be applied to the scan driver 150. The second control signal CS2 may be applied to the data driver 130.

The scan driver 150 may generate a plurality of scan signals, in response to the first control signal CS1. The plurality of scan signals may be applied to the plurality of sub-pixels PX through the plurality of scan lines SL1, ..., SLn.

The data driver 130 may generate a plurality of data voltages corresponding to the image data DATA, in response to the second control signal CS2. The plurality of data voltages may be applied to the plurality of sub-pixels PX through the plurality of data lines DL1, ..., DLm. The data driver 130 may simultaneously apply the data voltages, which are generated in units of sub-pixel rows, to the plurality of sub-pixels PX through the plurality of data lines DL1, ..., DLm.

The plurality of sub-pixels PX may receive the plurality of data voltages, in response to the plurality of scan signals. The plurality of sub-pixels PX may display an image by emitting light of luminance corresponding to the plurality of data voltages. The plurality of sub-pixels PX may display an image by emitting light sequentially or simultaneously.

Referring to FIGS. 1 to 3, each of the plurality of sub-pixels PX may include a first transistor T1, a second transistor T2, a third transistor T3, and a light-emitting element OLED, which is electrically connected to the first transistor T1.

Among the plurality of sub-pixels PX, a sub-pixel PX, which is connected to an i-th scan line 155 among the plurality of scan lines SL1, ..., SLn and a j-th data line 131 among the plurality of data lines DL1, ..., DLm, may be defined as a first sub-pixel PXₙ. Here, each of i and j may denote a natural number.

The i-th scan line 155 may include a first scan line 151 and a second scan line 152. The first scan line 151 and the second scan line 152 may transmit scan signals GWi and GC, respectively, to the first sub-pixel PXₙ.

The j-th data line 131 may transmit a data voltage VDATA to the first sub-pixel PXₙ. The data voltage VDATA may have a voltage level corresponding to the image signal RGB which is input to the display device 10.

A first voltage line 173 may transmit the first voltage ELVDD to the first sub-pixel PXₙ, a second voltage line 177 may transmit the second voltage ELVSS to the first sub-pixel PXₙ, and an initialization voltage line 174 may transmit the initialization voltage VINT to the first sub-pixel PXₙ.

Meanwhile, a first transistor T1 may be a P-type transistor which has a low-temperature polycrystalline silicon (LTPS) semiconductor layer. However, this is merely illustrative, and the first transistor T1 may be an N-type transistor.

The second and third transistors T2 and T3 may each be a P-type transistor having an oxide semiconductor layer. However, this is merely illustrative, and the second and/or third transistors T2 and/or T3 may be N-type transistors.

The first transistor T1 may include a first gate electrode, a first driving electrode, and a second driving electrode. The first gate electrode of the first transistor T1 may be connected to a first node N1, the first driving electrode may be connected to the first voltage line 173, and the second driving electrode may be connected to a second node N2. The first transistor T1 may be referred to as a driving transistor.

The second transistor T2 may include a second gate electrode, a first switching electrode, and a second switching electrode. The second gate electrode of the second transistor T2 may be connected to the first scan line 151, the first switching electrode may be connected to the first node N1, and the second switching electrode may be connected to a third node N3. The second transistor T2 may be referred to as a switching transistor or a scan transistor.

The third transistor T3 may include a third gate electrode, a first initialization electrode, and a second initialization electrode. The third gate electrode of the third transistor T3 may be connected to the second scan line 152, the first initialization electrode may be connected to the third node N3, and the second initialization electrode may be connected to the second node N2. The third transistor T3 may be referred to as an initialization transistor.

Meanwhile, each of the plurality of sub-pixels PX may further include a first capacitor Cst and a second capacitor Cpr.

A first electrode of the first capacitor Cst may be connected to the first node N1, and a second electrode of the first capacitor Cst may be connected to the initialization voltage line 174. The first capacitor Cst may be referred to as a storage capacitor.

The first capacitor Cst may store a voltage between the first node N1 and the initialization voltage line 174. An amount of driving current which flows through the first transistor T1 may be determined based on the voltage stored in the first capacitor Cst. The light-emitting element OLED may emit light based on the driving current.

A first electrode of the second capacitor Cpr may be connected to the third node N3, and a second electrode of the second capacitor Cpr may be connected to the j-th data line 131.

The second capacitor Cpr may store a voltage between the third node N3 and the j-th data line 131. The second capacitor Cpr may also initialize the first voltage ELVDD through the second node N2 and the third transistor T3.

The light-emitting element OLED may include a first electrode connected to the second node N2 and a second electrode connected to the second voltage line 177. The first electrode of the light-emitting element OLED may be referred to as an anode electrode or a pixel electrode, and the second electrode of the light-emitting element OLED may be referred to as a cathode electrode or a common electrode.

Referring to FIGS. 4 and 5, two sub pixels, i.e., a first sub-pixel PXₙ and a second sub-pixel PXₙ₊₁, which are arranged adjacent to each other in a second direction y perpendicular to a first direction x with respect to the first voltage line 173, may share the first voltage ELVDD with each other. In some embodiments, the first sub-pixel PXₙ and the second sub-pixel PXₙ₊₁ may be symmetrical with respect to the first voltage line 173.

Each of the first sub-pixel PXₙ and the second sub-pixel PXₙ₊₁ may include a first scan line 151, 151a, a second scan line 152, 152a, and an initialization voltage line 174 that are parallel to the first direction x.

In some embodiments, the second gate electrode or a second sub-gate electrode of the second transistor T2 of the first sub-pixel PXₙ may be connected to the first scan line 151 of the i-th scan line 155, the third gate electrode or a third sub-gate electrode of the third transistor T3 of the first sub-pixel PXₙ may be connected to the second scan line 152 of the i-th scan line 155, and the first driving electrode of the first transistor T1 of the first sub-pixel PXₙ may be connected to the first voltage line 173 which is shared with the second sub-pixel PXₙ₊₁.

The second electrode of the first capacitor Cst of the first sub-pixel PXₙ may be connected to the initialization voltage line 174 to which the initialization voltage VINT is applied, and the second electrode of the second capacitor Cpr of the first sub-pixel PXₙ may be connected to the j-th data line 131 to which the data voltage VDATA is applied.

The second gate electrode or a second sub-gate electrode of the second transistor T2 of the second sub-pixel PXₙ₊₁ may be connected to a first scan line 151a of an i+1-th scan line 155a, the third gate electrode or a third sub-gate electrode of the third transistor T3 of the second sub-pixel PXₙ₊₁ may be connected to a second scan line 152a of the i+1-th scan line 155a, and the first driving electrode of the first transistor T1 of the second sub-pixel PXₙ₊₁ may be connected to the first voltage line 173 which is shared with the first sub-pixel PXₙ.

The second electrode of the first capacitor Cst of the second sub-pixel PXₙ₊₁ may be connected to the initialization voltage line 174 to which the initialization voltage VINT is applied, and the second electrode of the second capacitor Cpr of the second sub-pixel PXₙ₊₁ may be connected to the j-th data line 131 to which the data voltage VDATA is applied.

Meanwhile, an i-th scan signal GWi which is transmitted to the first sub-pixel PXₙ through the first scan line 151 and an i+1-th scan signal GWi+1 which is transmitted to the second sub-pixel PXₙ₊₁ through the first scan line 151a may be sequentially generated in the scan driver 150.

Further, an i-th scan signal GC which is transmitted to the first sub-pixel PXₙ through the second scan line 152 and an i+1-th scan signal GC which is transmitted to the second sub-pixel PXₙ₊₁ through the second scan line 152a may be global gate signals for synchronizing the plurality of pixels PX.

Meanwhile, a longitudinal direction of each of the first scan line 151 of the i-th scan line 155, the second scan line 152 of the i-th scan line 155, the first voltage line 173, and the initialization voltage line 174, which may be connected to the first sub-pixel PXₙ, may be parallel to the first direction x.

A longitudinal direction of each of the first scan line 151a of the i+1-th scan line 155a, the second scan line 152a of the i+1-th scan line 155a, the first voltage line 173, and the initialization voltage line 174, which may be connected to the second sub-pixel PXₙ₊₁, may also be parallel to the first direction x.

That is, since the first sub-pixel PXₙ and the second sub-pixel PXₙ₊₁ share the first voltage line 173, the longitudinal direction of each of the first scan line 151 of the i-th scan line 155, the second scan line 152 of the i-th scan line 155, the first voltage line 173, the initialization voltage line 174, the first scan line 151a of the i+1-th scan line 155a, and the second scan line 152a of the i+1-th scan line 155a may be parallel to the first direction x.

Further, the j-th data line 131, through which the data voltage VDATA is applied to the first sub-pixel PXₙ and the second sub-pixel PXₙ₊₁, may be arranged in the second direction y perpendicular to the first direction x.

Accordingly, the display device 10 according to one embodiment may have improved integration density because the first sub-pixel PXₙ and the second sub-pixel PXₙ₊₁ share the first voltage line 173 without having first voltage lines individually.

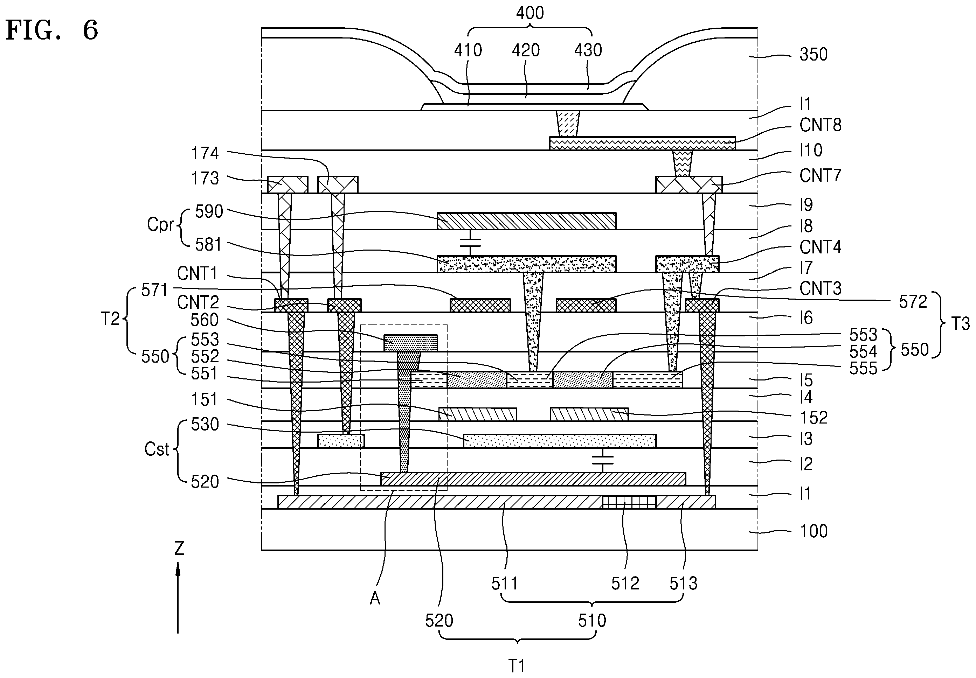

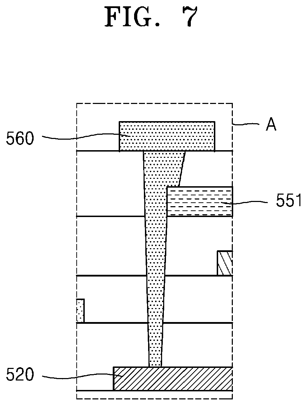

FIG. 6 is a schematic cross-sectional view illustrating a portion of the display device of FIG. 1, and FIG. 7 is an enlarged schematic cross-sectional view illustrating one example of a part A shown in FIG. 6 For example, FIG. 6 may illustrate an example of the pixel PX illustrated in FIGS. 1 to 5.

Referring to FIGS. 6 and 7 together with FIGS. 2 to 5, a sub-pixel PX according to one embodiment may include, on a substrate thereof, a first transistor T1, a second transistor T2 and a third transistor T3 positioned on the first transistor T1, a light-emitting element OLED positioned on the second transistor T2 and the third transistor T3 and electrically connected to the first transistor T1, a first capacitor Cst, and a second capacitor Cpr. The second transistor T2 and the third transistor T3 may be located on the same layer.

In some embodiments, the substrate 100 may be made of a transparent glass material mainly containing SiO₂. However, it is not limited thereto, and the substrate 100 may also be made of a transparent plastic material. The plastic material may be one selected from the group consisting of: include polyethersulphone (PES), polyacrylate (PAR), polyetherimide (PEI), polyethylene naphthalate (PEN), polyethyleneterepthalate (PET), polyphenylene sulfide (PPS), polyarylate, polyimide, polycarbonate (PC), cellulose triacetate (TAC), and cellulose acetate propionate (CAP).

A first semiconductor layer 510 may be formed on the substrate 100. The first semiconductor layer 510 may include a first source region 511, a first drain region 513, and a first channel region 512 located between the first source region 511 and the first drain region 513.

In some embodiments, the first semiconductor layer 510 may include a first source region 511 and a first drain region 513, which are doped with impurity, on respective opposite sides of the first channel region 512. Here, the impurity may vary depending on the type of the first transistor T1 and may include an N-type impurity or a P-type impurity. That is, the first channel region 512, the first source region 511 located on one side of the first channel region 512, and the first drain region 513 located on the other side of the first channel region 512 may be referred to as the first semiconductor layer 510.

The first source region 511 or the first drain region 513 which is formed by doping may also be interpreted as a source electrode (or a first driving electrode) or a drain electrode (or a second driving electrode) of the first transistor T1 in some cases. In some embodiments, the positions of the first source region 511 and the first drain region 513 may be switched with each other depending on the impurity doped to the first semiconductor layer 510.

The first semiconductor layer 510 may include polycrystalline silicon. For example, the first semiconductor layer 510 may be a layer that includes low-temperature polycrystalline silicon (LTPS), but is not limited thereto, and may also be a layer that includes an oxide semiconductor.

As an optional embodiment, a buffer layer may also be formed between the substrate 100 and the first semiconductor layer 510. The buffer layer may improve the characteristics of the polycrystalline silicon by shielding impurities during a crystallization process for forming the polycrystalline silicon, and a flat surface may be provided on the buffer layer.

A first insulating layer l1 may be formed on the first semiconductor layer 510 to cover the same. A first conductive layer including a first gate electrode 520 may be formed on the first insulating layer l1. On a plan view, the first gate electrode 520 may have an area which is wider than an area of the first channel region 512 of the first transistor T1.

The first gate electrode 520 may form the first transistor T1 together with the first semiconductor layer 510. The first transistor T1 may receive a first voltage ELVDD from the first source region 511 and supply a driving current to a light-emitting element 400.

The first gate electrode 520 may also serve as a first electrode 520 of the first capacitor Cst. Accordingly, the integration density of the display device 10 may be increased, and thus the areas of the first capacitor Cst and the first transistor T1 may be increased, thereby providing a high-quality image. However, the disclosure is not limited thereto. As another embodiment, the first electrode 520 of the first capacitor Cst may be an independent component, separate from the first gate electrode 520 of the first transistor T1.

A second insulating layer l2 may be formed on the first conductive layer to cover the same. A second conductive layer which includes a second electrode 530 of the first capacitor Cst may be formed on the second insulating layer l2. The second electrode 530 of the first capacitor Cst may form the first capacitor Cst together with the first electrode 520 of the first capacitor Cst.

A third insulating layer l3 may be formed on the second conductive layer to cover the same. A third conductive layer including a first scan line 151 and a second scan line 152, to which scan signals GWi and GC are applied, respectively, may be formed on the third insulating layer l3.

A fourth insulating layer l4 may be formed on the third conductive layer to cover the same. A second semiconductive layer 550 may be formed on the fourth insulating layer l4. The second semiconductor layer 550 may include a second source region 551, a second channel region 552, a second drain region 553, a third source region 553, a third channel region 554, and a third drain region 555.

The second channel region 552 may be located between the second source region 551 and the second drain region 553, and the third channel region 554 may be located between the third source region 553 and the third drain region 555. In some embodiments, the second drain region 553 and the third source region 553 may refer to the same region.

The positions of the second source region 551 and the second drain region 553 may be switched with each other depending on impurity doped to the second semiconductor layer 550, and the positions of the third source region 553 and the third drain region 555 may be switched with each other depending on impurity doped to the second semiconductor layer 550.

The second semiconductor layer 550 may be a layer that includes an oxide semiconductor, but is not limited thereto, and may alternatively be a layer that includes polycrystalline silicon, for example, low-temperature polycrystalline silicon (LTPS).

A fifth insulating layer l5 may be formed on the second semiconductor layer 550 to cover the same. A fourth conductive layer 560, which electrically connects the first gate electrode 520 and the second source region 551 of the second semiconductor layer 550 through a contact hole, may be formed on the fifth insulating layer l5. At least a portion of the fourth conductive layer 560 may overlap the first gate electrode 520 and the second semiconductor layer 550 in a vertical direction z.

In some embodiments, the contact hole connected to the fourth conductive layer 560 may expose a side surface of the second source region 551 of the second semiconductor layer 550, and may also expose at least a portion of an upper surface of the first gate electrode 520. Accordingly, the fourth conductive layer 560, the second source region 551, and the first gate electrode 520 may be electrically connected. For example, the fourth conductive layer 560 may be a first node N1 illustrated in FIG. 3.

That is, the first transistor T1 and the second transistor T2 may be arranged on different layers, and the first gate electrode 520 of the first transistor T1 and the second source region 551 of the second transistor T2 may be connected through a single contact hole, thereby providing the display device 10 with improved integration density.

A sixth insulating layer l6 may be formed on the fourth semiconductor layer 560 to cover the same. A fifth conductive layer, which includes a plurality of contacts CNT1, CNT2, and CNT3, a second gate electrode 571, and a third gate electrode 572, may be formed on the sixth insulating layer l6.

The second gate electrode 571 and the third gate electrode 572 may overlap the second channel region 552 and the third channel region 554, respectively. The second gate electrode 571 may form the second transistor T2 together with the second source region 551, the second channel region 552, and the second drain region 553. In some embodiments, the third gate electrode 572 may form the third transistor T3, which is located on the same layer as the second transistor T2, together with the third source region 553, the third channel region 554, and the third drain region 555.

Meanwhile, the first scan line 151 and the second scan line 152, which are located on the third insulating layer l3 and located on the same layer between the first transistor T1 and the second transistor T2, may be referred to as a second sub-gate electrode 151 and a third sub-gate electrode 152, respectively. As a result, the second sub-gate electrode 151 and the third sub-gate electrode 152 may form a dual gate of the second transistor T2 and a dual gate of the third transistor T3 together with the second gate electrode 571 and the third gate electrode 572, respectively.

The second sub-gate electrode 151 may be formed to overlap the second gate electrode 571. On a plan view, an area of the second sub-gate electrode 151 may be larger than an area of the second gate electrode 571. The third sub-gate electrode 152 may also be formed to overlap the third gate electrode 572. On a plan view, an area of the third sub-gate electrode 152 may be larger than an area of the third gate electrode 572.

When the second transistor T2 and the third transistor T3 have the dual gates, currents flowing along the second transistor T2 and the third transistor T3 may be controlled more precisely, switching speed of the second transistor T2 and the third transistor T3 may be improved by the interaction between the dual gates, and the second transistor T2 and the third transistor T3 may be driven with low power.

A seventh insulating layer l7 may be formed on the fifth conductive layer to cover the same. A sixth conductive layer, which includes a fourth contact CNT4 and a first electrode 581 of the second capacitor Cpr, may be formed on the seventh insulating layer l7.

The first electrode 581 of the second capacitor Cpr may be electrically connected between the second channel region 552 and the third channel region 554 of the second semiconductor layer 550 through one contact hole. The contact hole may expose at least a portion of an area between the second channel region 552 and the third channel region 554.

That is, the first electrode 581 of the second capacitor Cpr may be electrically connected to the second transistor T2 and the third transistor T3 through the single contact hole, other than two different contact holes, thereby improving the integration density of the display device 10.

An eighth insulating layer l8 may be formed on the sixth conductive layer to cover the same. A seventh conductive layer, which includes a second electrode 590 of the second capacitor Cst, may be formed on the eighth insulating layer l8.

The second electrode 590 of the second capacitor Cpr may be arranged to overlap the first electrode 581 of the second capacitor Cpr. The second electrode 590 of the second capacitor Cpr may also form the second capacitor Cpr together with the first electrode 581 of the second capacitor Cpr.

In some embodiments, the second electrode 590 of the second capacitor Cpr may include a data line 131 to which a data voltage VDATA is applied.

A ninth insulating layer l9 may be formed on the seventh conductive layer to cover the same. An eighth conductive layer may be formed on the ninth insulating layer l9. The eighth conductive layer may include a first voltage line 173 to which a first voltage ELVDD is applied, an initialization voltage line 174 to which an initialization voltage VINT is applied, and a seventh contact CNT7.

The first voltage line 173 may be connected to the first source region 511 of the first transistor T1 through the first contact CNT1 formed on the sixth insulating layer l6. This may allow the first voltage ELVDD to be applied to the first source region 511 of the first transistor T1.

The initialization voltage line 174 may be connected to the second electrode 530 of the first capacitor Cst through the second contact CNT2 formed on the sixth insulating layer l6. This may allow the initialization voltage VINT to be stored in the first capacitor Cst.

The first insulating layer l1, the second insulating layer l2, the third insulating layer l3, the fourth insulating layer l4, the fifth insulating layer l5, the sixth insulating layer l6, the seventh insulating layer l7, the eighth insulating layer l8, and the ninth insulating layer l9 may each be formed of silicon nitride and/or silicon oxide.

A tenth insulating layer l10 may be formed on the eighth conductive layer to cover the same. A ninth conductive layer including an eighth contact CNT8 may be formed on the tenth insulating layer l10.

The eighth contact CNT8 may be electrically connected to the third drain region 555 of the third transistor T3 and the first drain region 513 of the first transistor T1 through the fourth contact CNT4 located on the seventh insulating layer l7. The eighth contact CNT8 may also be electrically connected to a pixel electrode 410 of the light-emitting element 400. That is, the pixel electrode 410 of the light-emitting element 400 may be electrically connected to the first drain region 513 of the first transistor T1 and the third drain region 555 of the third transistor T3 through the eighth contact CNT8.

An eleventh insulating layer l11 may be formed on the ninth conductive layer to cover the same. The light-emitting element 400 may be positioned on the eleventh insulating layer l11, and may include a pixel electrode 410, a common electrode 430, and an intermediate layer 420 interposed between the pixel electrode 410 and the common electrode 430 and including an emission layer. The light-emitting element 400 may be, for example, an organic light-emitting diode (OLED).

In one embodiment, the pixel electrode 410 may be an anode of an organic light-emitting diode (OLED), and the common electrode 430 may be a cathode of the organic light-emitting diode (OLED). However, the disclosure is not limited thereto, and the pixel electrode 410 may be a cathode of the organic light-emitting diode (OLED) and the common electrode 430 may be an anode of the organic light-emitting diode (OLED), depending on a driving method of a display device. When holes and electrons are injected into the intermediate layer 420 from the pixel electrode 410 and the common electrode 430, respectively, excitons are produced by the combination of the injected holes and electrons. The excitons may change from an excited state to a ground state, thereby emitting light.

The tenth insulating layer l10 and the eleventh insulating layer l11 may each be formed of an organic material or a film stack including an organic material and an inorganic material. Examples of the organic material may include an imide-based polymer, a general-purpose polymer such as polymethylmethacrylate (PMMA) or polystyrene (PS), a polymer derivative having a phenolic group, an acryl-based polymer, an aryl ether-based polymer, an amide-based polymer, a fluorine-based polymer, a p-xylene-based polymer, a vinyl alcohol-based polymer, and a blend thereof.

The first to ninth conductive layers may include at least one of aluminum (Alr, platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), or copper (Cu).

Meanwhile, the pixel electrode 410 may be a translucent electrode or a reflective electrode. When the pixel electrode 410 is a translucent electrode, it may include, for example, ITO, IZO, ZnO, In2O3, IGO, or AZO. When the pixel electrode 410 is a reflective electrode, the pixel electrode 410 may have a reflective film, which includes Ag, Mg, Al, Pt, Pd, Au, Ni, Nd, Ir, Cr, and compounds thereof, and a layer formed of ITO, IZO, ZnO, In2O3, IGO, or AZO. Of course, the disclosure is not limited thereto, and the pixel electrode 410 may include various materials, and may also be modified in various ways, such as having a single-layer or multi-layer structure.

A pixel defining layer 350 covering an edge of the pixel electrode 410 may be arranged on the eleventh insulating layer l11. The pixel defining layer 350 may play a role or defining the pixel by having an opening corresponding to each pixel, that is, an opening exposing at least a central portion of the pixel electrode 410. The pixel defining layer 350 may also increase a distance between the edge of the pixel electrode 410 and the common electrode 430, thereby suppressing an occurrence of an arc therebetween. The pixel defining layer 350 may be formed of an organic material such as polyimide or hexamethyldisiloxane (HMDSO).

An intermediate layer 420 may be formed on the pixel electrode 410 which is exposed through the opening of the pixel defining layer 350. The intermediate layer 420 may include a low-molecular material or a high-molecular material. When the intermediate layer 420 includes a low-molecular material, the intermediate layer 420 may have a single-layer or multi-layer structure including a hole injection layer (HIL), a hole transport layer (HTL), an emission layer (EML), an electron transport layer (ETL), or an electron injection layer (ElL), and may include various organic materials including copper phthalocyanine (CuPc), N,N'-di(naphthalene-1-yl)-N,N'-diphenyl-benzidine (NPB), tris-8-hydroxyquinoline aluminum (Alq3), and the like. These layers may be formed by vacuum deposition.

When the intermediate layer 420 includes a high-molecular material, the intermediate layer 420 may usually have a structure including a hole transport layer (HTL) and an emission layer (EML). In this instance, the hole transport layer may include PEDOT, and the emission layer may include a high molecular weight material such as poly-phenylenevinylene (PPV)-based high-molecular material, and polyfluorene-based high-molecular material. The structure of the intermediate layer 420 is not limited to that described above and may have various structures. For example, the intermediate layer 420 may include a layer that is integrally formed throughout a plurality of pixel electrodes 410, or a layer that is patterned to correspond to each of the plurality of pixel electrodes 410.

The common electrode 430 may be arranged to cover the display area (DA in FIG. 1). That is, the common electrode 430 may be formed as an integral body to cover the plurality of light-emitting elements 400. The common electrode 430 may be a translucent electrode or a reflective electrode. When the common electrode 430 is a translucent electrode, the common electrode 430 may include a layer formed of a metal having a low work function, i.e., Li, Ca, LiF/Ca, LiF/Al, Al, Ag, Mg, and any compound thereof, and a translucent conductive layer such as ITO, IZO, ZnO, In2O3, or the like. When the common electrode 430 is a reflective electrode, the common electrode 430 may include a layer formed of Li, Ca, LiF/Ca, LiF/Al, Al, Ag, Mg, and any compound thereof. However, the configuration and materials of the common electrode 430 are not limited thereto and the common electrode 430 may be variously modified.

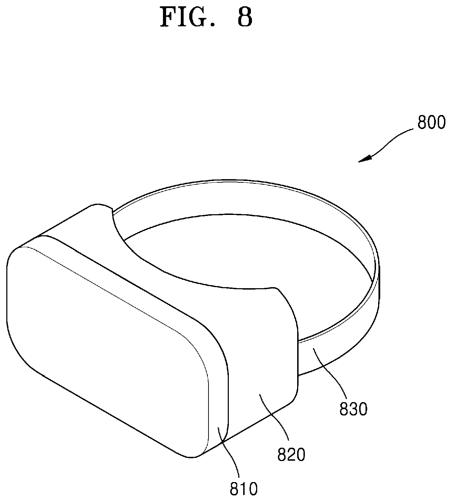

FIG. 8 is a schematic diagram of an example in which an electronic device including a display device according to embodiments is implemented as a head-mounted display.

Referring to FIG. 8, an electronic device including a display device may be implemented as a head-mounted display (HMD) 800. The HMD 800 may include a display unit 810, a main body unit 820, and a wearing unit 830.

For example, the display unit 810 may include the display device according to the embodiments of FIGS. 1 to 7 to implement a screen. The main body unit 820 may include a controller that applies a scan signal and a data signal to the display unit 810, a touch sensor, or an acoustic sensor. A user may wear the HMD 800 using the wearing unit 830.

However, this is merely illustrative and the electronic device is not limited to the HMD 800. For example, the electronic device may be any electronic device including a display device such as a virtual reality (VR) device, a mobile phone, a smart phone, a tablet computer, a digital television (TV), a three-dimensional (3D) TV, a personal computer (PC), a home appliance, a laptop computer, a personal digital assistant (PDA), a portable multimedia player (PMP), a digital camera, a music player, a portable game console, a navigator, etc.

According to one or more embodiments, two sub-pixels which are vertically adjacent to each other may share a first voltage line, and a first transistor and a second transistor may be positioned on different layers such that a gate electrode of the first transistor and a source or drain region of the second transistor are electrically connected through one contact hole, thereby providing a display device having improved integration density.

However, the effects obtainable through the disclosure are not limited to the effects described above, and other technical effects not mentioned will be clearly understood by those skilled in the art from the description of the disclosure described below.

While the disclosure has been herein described with regard to a limited number of embodiments and drawings, the disclosure is not limited thereto and it is obvious to those skilled in the art that various modifications and changes may be made thereto within the technical scope of the present disclosure as defined by the appended claims

## Claims

1. A display device (10) comprising:
a substrate (100);
a first transistor (T1) positioned on the substrate (100) and comprising a first semiconductor layer (510) and a first gate electrode (520);
a second transistor (T2) positioned on the first transistor (T1) and comprising a second semiconductor layer (550) and a second gate electrode (571); and
a light-emitting element (400) positioned on the second transistor (T2) and electrically connected to the first transistor (T1),
wherein the first gate electrode (520) of the first transistor (T1) and the second semiconductor layer (550) of the second transistor (T2) are electrically connected to each other through a contact hole.

2. A display device (10) comprising:
a substrate (100) comprising a display area (DA) and a peripheral area (PA) positioned outside the display area (DA);
a plurality of sub-pixels (PX) positioned in the display area (DA); and
a plurality of first voltage lines (173) extending in a first direction and configured to apply a first voltage (ELVDD) to the plurality of sub-pixels (PX),
wherein two sub-pixels (PX) share a first voltage line (173) of the plurality of first voltage lines (173), the two sub-pixels (PX) being arranged adjacent to each other in a second direction perpendicular to the first direction with respect to the first voltage line (173).

3. The display device (10) of claim 2, wherein
the two sub-pixels (PX) are symmetrical with respect to the first voltage line (173).

4. The display device (10) of claim 3, wherein
each of the plurality of sub-pixels (PX) comprises:
a substrate (100);
a first transistor (T1) positioned on the substrate (100) and comprising a first semiconductor layer (510) and a first gate electrode (520);
a second transistor (T2) positioned on the first transistor (T1) and comprising a second semiconductor layer (550) and a second gate electrode (571); and
a light-emitting element (400) positioned on the second transistor (T2) and electrically connected to the first transistor (T1),
wherein the first gate electrode (520) of the first transistor (T1) and the second semiconductor layer (550) of the second transistor (T2) are electrically connected to each other through a contact hole.

5. The display device (10) of claims 1 or 4, further comprising
a conductive layer (560) positioned on an insulating layer (IL5) which covers the second semiconductor layer (550), and electrically connected to the first gate electrode (520) and the second semiconductor layer (550) through the contact hole,
wherein at least a portion of the conductive layer (560) vertically overlaps the first gate electrode (520) and the second semiconductor layer (550).

6. The display device (10) of any one of claims 1, 4 or 5, wherein
the contact hole exposes a side surface of a source region (551) of the second transistor (T2).

7. The display device (10) of any one of claims 1 or 4 to 6, further comprising
a third transistor (T3) positioned on a same layer (IL4) as the second transistor (T2),
wherein the third transistor (T3) comprises the second semiconductor layer (550) and a third gate electrode (572).

8. The display device (10) of claim 7, further comprising
a first scan line (151, 151a) and a second scan line (152, 152a) positioned on a same layer (IL3) between the first transistor (T1) and the second transistor (T2),
wherein the first scan line (151, 151a) forms a dual gate of the second transistor (T2) together with the second gate electrode (571), and
the second scan line (152, 152a) forms a dual gate of the third transistor (T3) together with the third gate electrode (572).

9. The display device (10) of claim 8, wherein
the first scan line (151, 151a) and the second scan line (152, 152a) are arranged parallel to each other.

10. The display device (10) of claim 8 or 9, further comprising
a first voltage line (173) and an initialization voltage line (174) positioned on a same layer (IL9) between the second gate electrode (571) and the light-emitting element (400).

11. The display device (10) of claim 10, wherein
the first voltage line (173) and the initialization voltage line (174) are arranged parallel to the first scan line (151, 151a).

12. The display device of claim 11, wherein
two sub-pixels (PX) share a first voltage (ELVDD), the two sub-pixels (PX) being arranged adjacent to each other in a direction perpendicular to a longitudinal direction of the first voltage line (173) with respect to the first voltage line (173).

13. The display device (10) of any one of claims 1 or 4 to 12, wherein
the first semiconductor layer (510) comprises polycrystalline silicon and the second semiconductor layer (550) comprises an oxide semiconductor.

14. The display device (10) of any one of claims 1 or 4 to 13, wherein
an area of the first gate electrode (520) is larger than an area of a channel region (553) of the first transistor (T1) on a plan view.

15. An electronic device comprising a display device (10) according to any one of the preceding claims.
